# EUROPÄISCHE PATENTSCHRIFT

(11) **EP 3 574 333 B1**
(45) Veröffentlichungstag und Bekanntmachung des Hinweises auf die Patenterteilung: **11.01.2023**
(21) Anmeldenummer: 18704164.5
(22) Anmeldetag: 26.01.2018
(51) Int. Cl.: G02B 6/12, G01R 31/317

(54) **VORRICHTUNG UND VERFAHREN ZUM TESTEN VON PHOTONISCHEN INTEGRIERTEN SCHALTUNGEN**
DEVICE AND METHOD FOR TESTING PHOTONIC INTEGRATED CIRCUITS
DISPOSITIF ET PROCÉDÉ POUR L'ESSAI DE CIRCUITS INTÉGRÉS PHOTONIQUES

(30) Priorität: 27.01.2017 DE 102017101626
(43) Veröffentlichungstag der Anmeldung: 04.12.2019
(73) Patentinhaber: Carl Zeiss SMT GmbH, 73447 Oberkochen (DE)
(72) Erfinder: HÜBNER, Philipp, 22083 Hamburg (DE); RICHTER, Stefan, 07743 Jena (DE)
(74) Vertreter: Sticht, Andreas
(86) Internationale Anmeldenummer: PCT/EP2018/051939
(87) Internationale Veröffentlichungsnummer: WO 2018/138249

(56) Entgegenhaltungen:
- DE-A1-102010 029 612
- US-A1- 2014 043 050
- US-A1- 2014 147 079
- US-B1- 9 453 723

## Beschreibung

Die vorliegende Anmeldung betrifft Vorrichtungen, Verfahren und Vorrichtungen mit Probenhaltern zum Testen von photonischen integrierten Schaltungen (PIC, Photonic Integrated Circuit).

In ähnlicher Weise wie bei elektronischen integrierten Schaltungen werden in photonischen integrierten Schaltungen eine Vielzahl passiver und/oder aktiver optischer und optoelektronischer Komponenten auf einem gemeinsamen Substrat, zum Beispiel einem Halbleiterwafer, zu komplexen optischen Schaltungen zusammen gesetzt. Dabei können traditionelle optische Komponenten wie beispielsweise Filter oder Koppler durch kompaktere integrierte optische Komponenten ersetzt werden. Über Wellenleiter nahe der Oberfläche der photonischen integrierten Schaltung werden die unterschiedlichen Komponenten der photonischen integrierten Schaltung miteinander verbunden. Derartige photonische integrierte Schaltungen wurden in den letzten Jahren mit dem starken Anwachsen von Datenverkehr im Internet interessanter, da hier Signalverarbeitungsschaltungen benötigt werden, die genügend Bandbreite aufweisen und die effizient arbeiten. Abgesehen von Telekommunikations- und Datenübertragungsanwendungen sind photonische integrierte Schaltungen auch für andere Anwendungen wie die Sensortechnik und für biowissenschaftliche Anwendungen interessant.

Der Herstellungsprozess derartiger photonischer integrierter Schaltungen ähnelt dem Herstellungsprozess herkömmlicher elektronischer integrierter Schaltungen oder mikroelektromechanischer Systeme (MEMS). Im Gegensatz zu diesen herkömmlichen Technologien existieren jedoch für photonische integrierte Schaltungen nur wenige Testverfahren, mit welcher derartige Schaltungen während des Herstellungsprozesses oder auch danach effizient überprüft werden können.

Zum Testen der photonischen integrierten Schaltungen, insbesondere der Wellenleiterstrukturen darin, ist es nötig, Licht in die Wellenleiterstrukturen der photonischen integrierten Schaltung einzukoppeln und Licht von der photonischen integrierten Schaltung, insbesondere von den Wellenleiterstrukturen, zu detektieren.

Herkömmlicherweise werden hierfür lichtleitende Fasern, beispielsweise Glasfasern, zu der zu testenden photonischen integrierten Schaltung ausgerichtet und somit positioniert. Da hierfür eine hohe Genauigkeit im Bereich kleiner als 1 µm erforderlich ist, wird hierfür vergleichsweise viel Zeit benötigt, was das Testen sehr zeitaufwändig macht. Daher ist ein derartiges Testen für hohe Stückzahlen nur bedingt geeignet, bzw. ist bei derartigen Stückzahlen zeit- und kostenintensiv, da die Positionierung vor jedem Test und für jede Schaltung separat erfolgen muss.

Die US 9,453,723 B1 offenbart ein Verfahren zum Testen einer photonischen integrierten Schaltung, wobei ein Beleuchtungsort eines Beleuchtungslichtstrahls zum Beleuchten der photonischen integrierten Schaltung ausgewählt wird und von der photonischen integrierten Schaltung ausgehendes Detektionslicht detektiert wird.

Die DE 10 2010 029 612 A1 offenbart eine Einkoppelvorrichtung zum Einkoppeln von Licht in einen planaren Wellenleiter, wobei eine Glasfaser mit Mikrometerschrauben ausgerichtet wird oder auf einen Wellenleiter aufgesetzt wird.

Aus diesen Gründen beschränken sich heutige Tests von photonischen integrierten Schaltungen hauptsächlich auf topologische Analysen und funktionales Überprüfen der fertigen Bauelemente.

Es ist daher eine Aufgabe, verbesserte Möglichkeiten zum Testen derartiger photonischer integrierter Schaltungen bereitzustellen.

Es werden eine Vorrichtung zum Testen photonischer integrierter Schaltungen nach Anspruch 1 sowie ein Verfahren nach Anspruch 14 bereitgestellt. Die Unteransprüche definieren weitere Ausführungsformen.

Gemäß einem ersten Aspekt wird eine Vorrichtung zum Testen photonischer integrierter Schaltungen, wie in Anspruch 1 definiert, bereitgestellt.

Der Begriff "Licht" umfasst dabei sowohl Licht im sichtbaren Bereich als auch Licht außerhalb desselben, z.B. Infrarotlicht. "Detektionslicht" bezeichnet das in Antwort auf das Beleuchten von der photonischen integrierten Schaltung ausgehende Licht, welches detektiert werden soll. Eine Scaneinrichtung ist dabei allgemein eine Einrichtung, mit welcher eine Fläche in diesem Fall die photonische integrierte Schaltung oder Umgebung hiervon, mit einem Lichtstrahl abgerastert werden kann bzw. der Lichtstrahl zielgenau auf einer Einkoppelstruktur eines Wellenleiters der photonischen integrierten Schaltung positioniert werden kann. Durch das Bereitstellen einer derartigen Scaneinrichtung ist kein mechanisches Ausrichten von Glasfasern erforderlich, sondern eine Einkopplung kann zielgenau mittels der Scaneinrichtung erfolgen.

Die Vorrichtung kann weiter eine Pupillenauswahleinrichtung umfassen, um eine Position des Beleuchtungslichtstrahls in einer Pupillenebene des Beleuchtungspfades festzulegen, um so einen Beleuchtungswinkel einzustellen.

Eine Pupillenauswahleinrichtung beschränkt dabei den Lichtstrahl auf einen Teil einer Pupille einer zum Beleuchten der photonischen integrierten Schaltung verwendeten Optik. Hierdurch kann neben dem Ort der Beleuchtung der auch ein Einfallswinkel auf die photonische integrierte Schaltung eingestellt werden.

Die Pupillenauswahleinrichtung kann eine erste verstellbare Spiegeleinrichtung und eine zweite verstellbare Spiegeleinrichtung, z.B. einen ersten biaxial verstellbaren Spiegel und einen zweiten biaxial verstellbaren Spiegel, zwei Paare von uniaxialen Spiegeln, z.B. Spiegel mit galvanometrischem Antrieb (auch als Galvo-Spiegel bezeichnet), akusto-optische Modulatoren und/oder akusto-optische Deflektoren umfassen. Eine verstellbare Spiegeleinrichtung ist dabei allgemein eine Einrichtung, die Licht ablenkt, wobei die Lichtablenkung, z.B. ein Winkel der Lichtablenkung, verstellbar ist.

Zusätzlich oder alternativ kann die Pupillenauswahleinrichtung einen räumlichen Lichtmodulator umfassen.

Der räumliche Lichtmodulator kann eingerichtet sein, mindestens zwei Beleuchtungslichtstrahlen zu erzeugen. So sind simultane Einkopplungen an verschiedenen Stellen der photonischen integrierten Schaltung möglich.

Die Detektionseinrichtung kann einen 2D-Detektor umfassen, d.h. einen Detektor, mit dem Licht von der photonischen integrierten Schaltung flächig und insbesondere ortsaufgelöst detektiert werden kann.

Der 2D-Detektor kann einen Bildsensor umfassen, z.B. einen CCD-Sensor oder einen CMOS-Sensor.

Zusätzlich oder alternativ kann die Detektionseinrichtung einen Punktdetektor umfassen.

Die Detektionseinrichtung kann auch ein Spektrometer und/oder ein im Zeitbereich arbeitendes optisches Reflektometer umfassen.

Der Detektionspfad für das Detektionslicht kann die Scaneinrichtung umfassen. In diesem Fall kann das Detektionslicht am Beleuchtungsort detektiert werden.

Der Detektionspfad für das Detektionslicht kann aber auch eine weitere Scaneinrichtung umfassen. In diesem Fall kann das Detektionslicht an einem unabhängig von dem Beleuchtungsort einstellbaren Ort detektiert werden.

Die Vorrichtung wie oben beschrieben kann einen Probenhalter aufweisen, wobei der Probenhalter eine Aufnahme für die photonische integrierte Schaltung und eine um die Aufnahme herum angeordnete Strahlablenkungseinrichtung zum Ablenken eines Lichtstrahls zu oder von der Vorrichtung umfasst. Mit einem derartigen Probenhalter kann Licht insbesondere seitlich in die photonische integrierte Schaltung eingekoppelt werden oder aus dieser ausgekoppelt werden. "Um herum" bedeutet in diesem Zusammenhang, dass die Strahlablenkungseinrichtung an Seiten der Aufnahme angeordnet ist, sodass, wenn eine photonische integrierte Schaltung in der Aufnahme angeordnet ist, die Strahlablenkungseinrichtung seitlich der integrierten Schaltung und diese ganz oder teilweise umgebend angeordnet ist.

Die Strahlablenkungseinrichtung kann ein Prisma und/oder einen Spiegel umfassen.

Eine nicht beanspruchte photonische integrierte Schaltung zur Verwendung mit einer Vorrichtung wie oben beschrieben kann mindestens eine Wellenleiterebene und mindestens ein Kopplungsgitter umfassen, welches auf einer Oberfläche der photonischen integrierten Schaltung angeordnet ist, die parallel zu der Wellenleiterebene liegt. Mit dem Kopplungsgitter kann der Beleuchtungslichtstrahl von der Vorrichtung in die Wellenleiterebene eingekoppelt werden und das Detektionslicht aus diesem ausgekoppelt werden.

Gemäß einem weiteren Aspekt wird ein Verfahren zum Testen einer photonischen integrierten Schaltung, wie in Anspruch 14 definiert, bereitgestellt.

Mit einem derartigen Verfahren können photonische integrierte Schaltungen schnell und kostengünstig untersucht werden.

Das Verfahren kann weiter ein Wählen eines Beleuchtungswinkels des Lichtstrahls durch Einstellen einer Position des Beleuchtungslichtstrahls in einer Pupillenebene eines Beleuchtungspfades für den Beleuchtungslichtstrahl umfassen.

Das Verfahren kann weiterhin ein Auswählen eines Detektionsortes für das Detektionslicht umfassen.

Die Erfindung wird nachfolgend anhand von Ausführungsbeispielen näher erläutert. Es zeigen:
Fig. 1 ein Blockdiagram einer Vorrichtung gemäß einem Ausführungsbeispiel,
Figuren 2-5 Beleuchtungspfade für Vorrichtungen gemäß verschiedenen Ausführungsbeispielen,
Figuren 6-9 Vorrichtungen gemäß verschiedenen Ausführungsbeispielen mit verschiedenen Detektionspfaden,
Figuren 10 und 11 Proben und Probenhalter gemäß verschiedenen Ausführungsbeispielen, und
Fig. 12 ein Flussdiagram zur Veranschaulichung eines Verfahrens gemäß einem Ausführungsbeispiel.

Die Erfindung wird nachfolgend anhand verschiedener Ausführungsbeispiele detailliert erläutert. Es ist zu bemerken, dass diese Ausführungsbeispiele nur zur Veranschaulichung dienen und nicht als einschränkend anzusehen sind. Zu bemerken ist auch, dass anhand der verschiedenen Varianten der im Folgenden dargestellten Vorrichtungen Pfade zum Einkoppeln von Licht in eine photonische integrierte Schaltung (Beleuchtungspfade) und Pfade zum Detektieren von Licht (Detektionspfade), welches von photonischen integrierten Schaltung ausgeht, getrennt diskutiert werden. Diese Anregungs- und Detektionspfade können im Wesentlichen in beliebiger Weise kombiniert werden.

Zudem können zusätzlich zu den dargestellten optischen Komponenten auch weitere optische Komponenten bereitgestellt sein. Beispielsweise können Lichtpfade (Beleuchtungs- oder Detektionspfade) mittels einer oder mehrerer Spiegel ein- oder mehrfach abgewinkelt werden, beispielsweise um ein kompaktere Bauweise zu ermöglichen. Dargestellte Linsen dienen lediglich als Beispiel und können auch durch Gruppen von Linsen und/oder anderer strahlformende Elemente, beispielsweise diffraktive Elemente, realisiert sein, so lange die wesentliche Funktion der jeweiligen optischen Elemente erhalten bleibt.

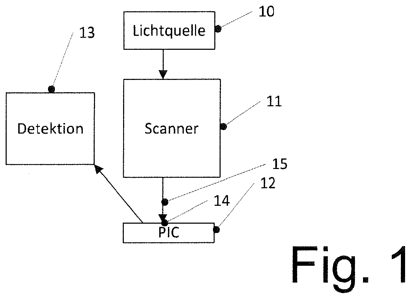

Die Fig. 1 zeigt ein Blockdiagram einer Vorrichtung gemäß einem Ausführungsbeispiel. Die Vorrichtung der Fig. 1 umfasst eine Lichtquelle 10 zum Erzeugen eines Lichtstrahls 15 (die Bezeichnung Lichtstrahl dient hier der einfachen Bezeichnung, und schließt die Möglichkeit mehrerer Teilllichtstrahlen und/oder eines Strahlenbündels ein). Bei einem bevorzugten Ausführungsbeispiel ist die Lichtquelle 10 eine Laserlichtquelle. Bei manchen Ausführungsbeispielen kann die Lichtquelle 10 polarisiertes Licht erzeugen, beispielsweise mittels eines Polarisators, um eine photonische integrierte Schaltung 12 mit polarisiertem Licht zu beleuchten.

Die Vorrichtung der Fig. 1 umfasst weiterhin eine Scaneinrichtung 11, mittels der eine Position 14 des Lichtstrahls auf der photonischen integrierten Schaltung 12 veränderbar ist. Die Scaneinrichtung 11 kann hierzu insbesondere einen oder mehrere bewegliche Scanspiegel und/oder räumliche Lichtmodulatoren aufweisen. Hierdurch kann mittels der Scaneinrichtung 11 die Position 14 präzise eingestellt werden, ohne dass eine Positionierung von Glasfasern oder anderen lichtleitenden Fasern wie beim Stand der Technik erforderlich ist.

Bevorzugt ermöglicht die Scaneinrichtung 11 auch eine Einstellung des Winkels, unter dem der Lichtstrahl 15 auf die photonische integrierte Schaltung 12 trifft, so dass beispielsweise ein passender Einkopplungswinkel für Wellenleiterstrukturen der photonischen integrierten Schaltung 12 gewählt werden kann. Wie später noch näher erläutert werden wird, kann dies insbesondere mittels einer Pupillenauswahleinrichtung erfolgen, mittels der der Lichtstrahl 15 in einer Pupillenebene einer Optik der Scaneinrichtung 11 verfahren wird. In anderen Worten wird nicht die gesamte Pupille beispielsweise eines verwendeten Objektivs ausgenutzt, wodurch der Einfallswinkel und das Winkelspektrum des Lichtstrahls 15 (d.h. von Teillichtstrahlen hiervon) innerhalb gewisser Grenzen einstellbar ist. Dies wird später noch näher erläutert.

Des Weiteren umfasst die Vorrichtung der Fig. 1 eine Detektionseinrichtung 13, mit welcher von der photonischen integrierten Schaltung 12 ausgehendes Licht, insbesondere Licht aus Wellenleiterstrukturen der photonischen integrierten Schaltung 12, detektiert werden kann. Diese Detektion kann simultan für die gesamte photonische integrierte Schaltung 12, beispielsweise mittels einer Kamera oder einem anderen 2D-Sensor, oder auch ortsaufgelöst, beispielsweise mit einer weiteren Scaneinrichtung, erfolgen.

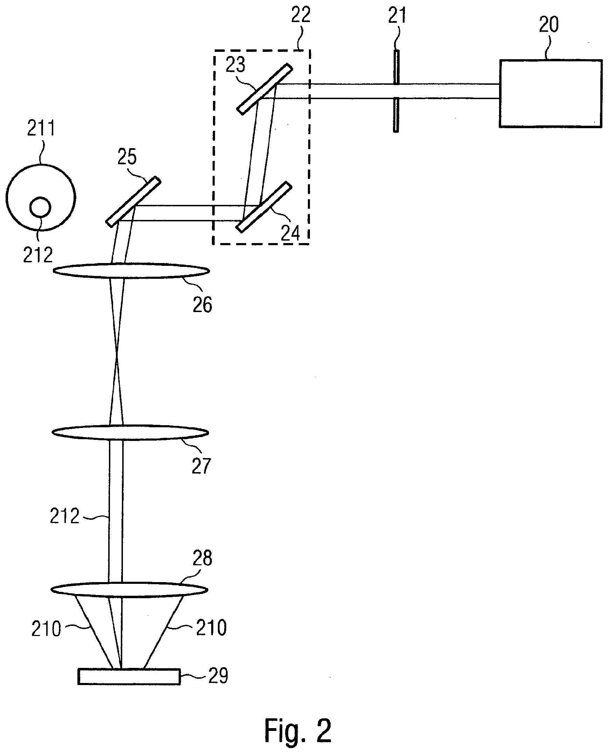

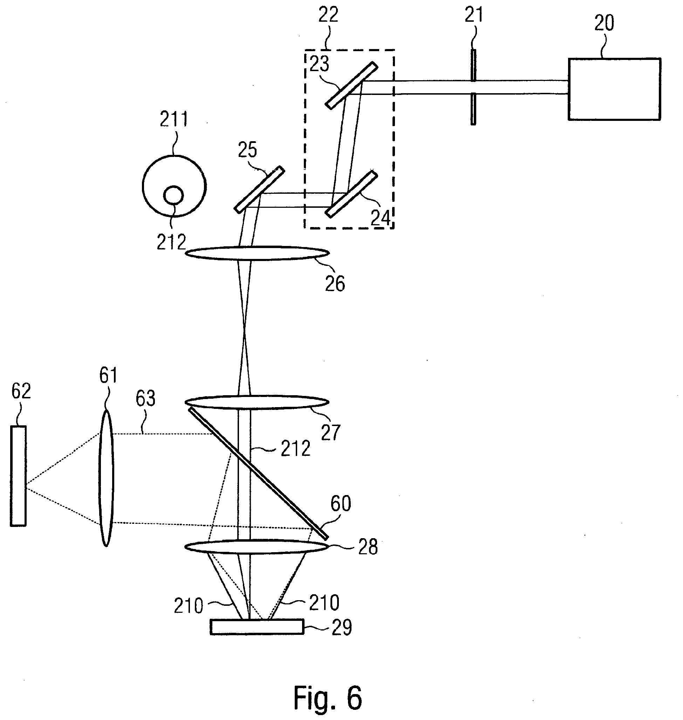

Der Lichtpfad mit der Lichtquelle 10 und der Scaneinrichtung 11, welche zum Beleuchten der photonischen integrierten Schaltung 12 mit dem Lichtstrahl 15 dient, wird im Folgenden auch als Beleuchtungspfad bezeichnet, und der Lichtpfad zur Detektion mit der Detektionseinrichtung 13 wird als Detektionspfad bezeichnet. Verschiedene Ausführungsbeispiele für die Implementierung des Beleuchtungspfads und des Detektionspfades werden im Folgenden unter Bezugnahme auf die Figuren 2-9 erläutert, wobei anhand der Figuren 2-5 Implementierungsmöglichkeiten für den Beleuchtungspfad und anhand der Figuren 6-9 Implementierungsmöglichkeiten für den Detektionspfad erläutert werden. Zur Vermeidung von Wiederholungen tragen in den Figuren 2-9 einander entsprechende Elemente die gleichen Bezugszeichen und werden nicht mehrmals erläutert. Die beschriebenen Beleuchtung- und Detektionspfade benutzen teilweise Prinzipien, welche aus der Laserscanning-Mikroskopie (LSM) bekannt sind, und übertragen diese auf das Testen photonischer integrierter Schaltungen. Es können daher auch andere, in den Figuren nicht dargestellte Elemente, welche herkömmlicherweise in Laserscanning-Mikroskopen verwendet werden, auch bei Ausführungsbeispielen der vorliegenden Erfindung eingesetzt werden.

Die Fig. 2 zeigt einen Beleuchtungspfad einer Vorrichtung zum Testen einer photonischen integrierten Schaltung 29 gemäß einem Ausführungsbeispiel. Die Vorrichtung der Fig. 2 umfasst einen Laser 20 zum Erzeugen eines Beleuchtungslichtstrahls 212, welcher dazu dient, die photonische integrierte Schaltung 29 zu beleuchten, insbesondere um einen Wellenleiter der photonischen integrierten Schaltung 29 eingekoppelt zu werden. Der Laser 20 kann dabei Licht mit einer gewünschten Polarisation erzeugen, wozu auch (nicht dargestellte) Polarisatoren oder polarisationsdrehende Elemente bereitgestellt sein können.

Der Lichtstrahl, welcher von dem Laser 20 ausgeht, wird durch eine Aperturblende 21 hinsichtlich seiner Apertur eingestellt (begrenzt) und gelangt dann zu einer Beamwalk-Einrichtung 22 mit Spiegeln 23, 24, deren Funktion später noch näher erläutert werden wird. Von der Beamwalk-Einrichtung 22 gelangt der Beleuchtungslichtstrahl 212 zu einem Scanspiegel 25, welcher beweglich, insbesondere verkippbar, ist, wodurch eine Position des Lichtstrahls 212 auf oder bei der photonischen integrierten Schaltung 29 einstellbar ist. Statt der Apertur 21 kann auch eine Strahlaufweitungs/-einengungsanordnung, z.B. ähnlich einer Teleskopanordnung, vorgesehen sein. Der Scanspiegel 25 kann auf verschiedene Weise realisiert sein, beispielsweise mittels eines galvanischen Spiegels, einer oder mehrerer mikromechanischer Spiegel oder räumlicher Lichtmodulatoren. Allgemein kann jedes Element als Scanspiegel 25 verwendet werden, welches eine steuerbare Ablenkung des Lichtstrahls 212 ermöglicht.

Von dem Scanspiegel 25 wird der Beleuchtungslichtstrahl 212 über eine Scanlinse 26, eine Tubuslinse 27 und einer Objektivlinse 28 auf die photonische integrierte Schaltung 29 abgebildet, wobei die photonische integrierte Schaltung 29 bei dem Ausführungsbeispiel der Fig. 2 in einem Fokuspunkt der durch die Linsen 26, 27 und 28 gebildeten optischen Anordnung liegt. Diese optische Anordnung ist lediglich als Beispiel für eine Linsenanordnung zu verstehen, und es können auch andere Linsenanordnungen, beispielsweise andere herkömmlicherweise in Laserscanning-Mikroskopen verwendete Linsenanordnungen, zum Einsatz kommen. Mit dem Bezugszeichen 210 sind "Randstrahlen" der Objektivlinse 28 bezeichnet.

Wie bereits erläutert kann mittels des Scanspiegels 25 eine Position des Beleuchtungslichtstrahls 212 auf der photonischen integrierten Schaltung 29 eingestellt werden. Zudem kann, wie nun erläutert werden wird, mittels der Beamwalk-Einrichtung 22 ein Einfallswinkels des Lichtstrahls 212 auf de photonischen integrierten Schaltung 29 eingestellt werden.

Durch die Beschränkung der Apertur durch die Aperturblende 21 füllt der Lichtstrahl 212 nur einen Teil einer Pupillenebene 211, wobei der Scanspiegel 25 in der Pupillenebene angeordnet ist, aus. Die Linsen 26, 27 dienen dabei dazu, die Pupillenebene der Objektivlinse 28 gleichsam zu dem Ort des Scanspiegels 25 hin zu "verlegen". Die Beamwalk-Einrichtung 22 umfasst die Spiegel 23 und 24, wobei bei dem Ausführungsbeispiel der Fig. 2 die Spiegel 23 und 24 biaxial verkippbar sind. Andere Verschiebungsmöglichkeiten oder Verkippmöglichkeiten der Spiegel 23, 24 sind ebenso realisierbar. Durch Bewegung der Spiegel 23 und/oder 24 kann der Lichtstrahl 212 in der Pupillenebene 211 verschoben werden. Dies verändert den Einfallswinkel des Lichtstrahls 212 auf der photonischen integrierten Schaltung 29. Somit kann auf diese Weise, indem nur ein Teil der Pupillenebene ausgenutzt wird, auch der Einfallswinkel des Lichtstrahls 12 auf photonischen integrierten Schaltung verändert werden. Die Aperturblende 21 kann dabei verstellbar sein. Auf diese Weise kann ein "Winkelspektrum" bzw. Winkelbereich, unter dem der Lichtstrahl 212 auf die photonische integrierte Schaltung 29 fällt, ausgewählt werden.

Durch die Bewegung des Scanspiegels 25 kann dabei insbesondere der Lichtstrahl 212 auf Einkopplungsorte der photonischen integrierten Schaltung 29, beispielsweise Einkopplungsgitter, gerichtet werden.

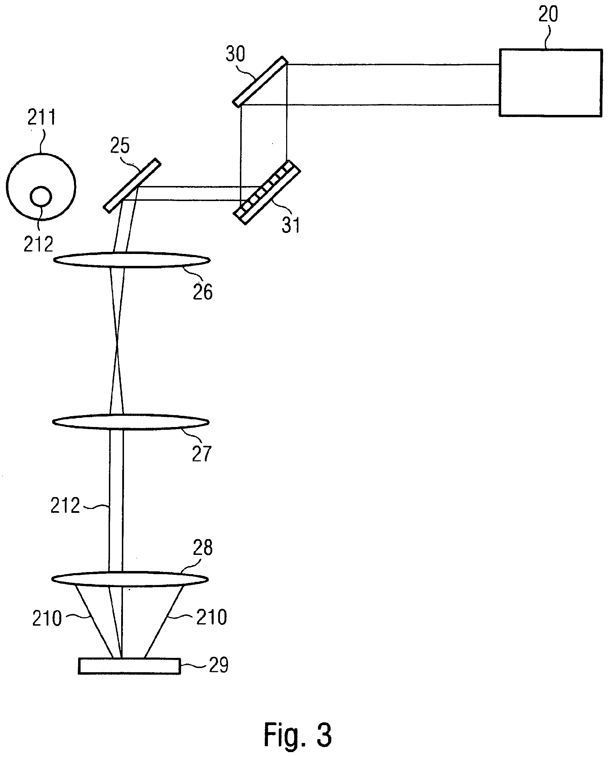

Die Fig. 3 zeigt eine Alternative zu der Bereitstellung der Aperturblende 21 und der Beamwalk-Einrichtung 22. Statt diesen Elementen ist bei dem Ausführungsbeispiel in Fig. 3 ein Spiegel 30 zusammen mit einem räumlichen Lichtmodulator 31 bereitgestellt. Der räumliche Lichtmodulator (SLM, Spatial Light Modulator) 31 kann beispielsweise als digitale Mikrospiegelanordnung (DMD, Digital Mirror Device), als Flüssigkristallanzeige (LCD, Liquid Crystal Display) oder Flüssigkristall- auf - Silizium (LCoS, Liquid Crystal on Silicon) ausgestaltet sein. Mittels des räumlichen Lichtmodulators 31 kann ein Teil des von dem Laser 20 emittierten Lichtstrahls der Lichtstrahl 212 ausgewählt werden, so dass wiederum nur ein auswählbarer Teil der Pupille 211 genutzt wird und ein Beleuchtungswinkel einstellbar ist.

Manche räumliche Lichtmodulatoren, beispielsweise LCD und LCoS Modulatoren, ermöglichen es dabei zusätzlich, auch die Phase des Lichtstrahls einzustellen und ermöglichen daher große Freiheiten bei der Strahlformung, beispielsweise Mehrfachstrahlanordnungen oder Besselstrahlen, welche für manche Untersuchungen und Tests von photonischen integrierten Schaltungen hilfreich sind.

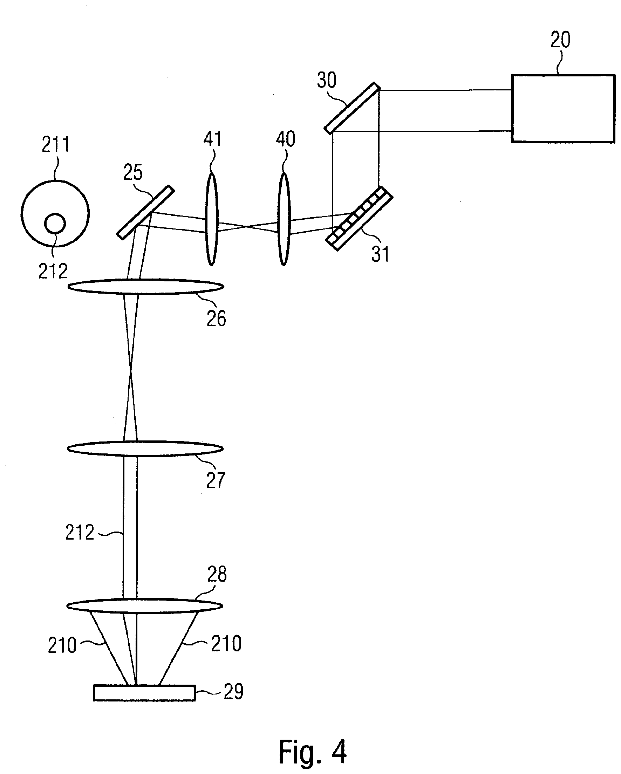

Eine Variante des Ausführungsbeispiels der Fig. 3 ist in der Fig. 4 dargestellt. Bei der Fig. 4 sind zwischen dem räumlichen Lichtmodulator 31 und dem Scanspiegel 25 Linsen 40, 41 angeordnet, welche eine zusätzliche Strahlformung ermöglichen. Diese stellen ein Beispiel für zusätzliche optische Elemente dar, welche im Beleuchtungspfad angeordnet sein können.

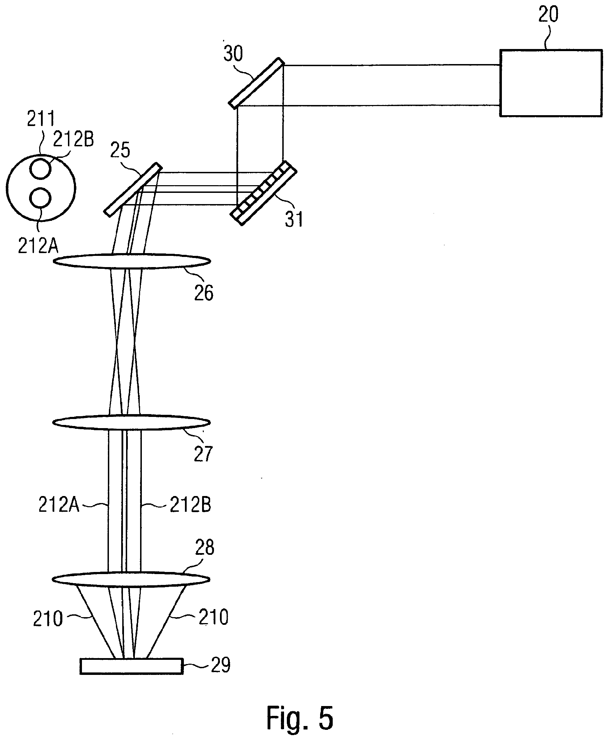

Die Fig. 5 zeigt eine Einsatzmöglichkeit des Ausführungsbeispiels der Fig. 3 zur Beleuchtung an mehreren Punkten der photonischen integrierten Schaltung 29. Hier werden mittels des räumlichen Lichtmodulators 31 zwei Beleuchtungslichtstrahlen 212A, 212B an verschiedenen Stellen der Pupille 211 erzeugt, was zu einer Beleuchtung der photonischen integrierten Schaltung an zwei verschiedenen Orten führt. Auf diese Weise kann Licht an mehreren Orten parallel in die photonische integrierte Schaltung 29 eingekoppelt werden, was zusätzliche Testmöglichkeiten eröffnet. Dabei ist zu bemerken, dass die Anzahl von zwei getrennten Beleuchtungslichtstrahlen nur ein Beispiel ist, und mittels des räumlichen Lichtmodulators 31 auch mehr als zwei Strahlen erzeugt werden können.

Als nächstes werden unter Bezugnahme auf die Figuren 6-9 (9A und 9B) verschiedene Möglichkeiten zur Detektion von der photonischen integrierten Schaltung 29 in Antwort auf die Beleuchtung von ausgehendem Detektionslicht erläutert. Als Beispiel für einen Beleuchtungspfad wird dabei in den Figuren 6-9 der Beleuchtungspfad der Fig. 2 verwendet. Bei anderen Ausführungsbeispielen kann hier jedoch ebenso der Beleuchtungspfad einer der Ausführungsbeispiele der Figuren 3-5 verwendet werden. Allgemein muss der Detektionspfad nicht so strenge Kopplungserfordernisse hinsichtlich Winkel und gegebenenfalls auch Polarisierung erfüllen wie der Beleuchtungspfad.

Bei dem Ausführungsbeispiel der Fig. 6 wird ein 2D-Detektor 62, d.h. ein flächiger Detektor wie ein Bildsensor, beispielsweise ein CCD - oder CMOS Bildsensor, verwendet, um eine Detektion innerhalb eines großen Beobachtungsfeldes (FOV, Field of View) vorzunehmen. Hierzu ist bei dem Ausführungsbeispiel der Fig. 6 ein Strahlteiler 60 bereitgestellt, welcher das von der photonischen integrierten Schaltung 29 ausgehende Detektionslicht 63 aus dem Beleuchtungspfad auskoppelt. Das Detektionslicht 63 wird dann mittels einer Kameralinse 61 (welche wiederum nur als Beispiel dient und auch ein aus mehreren Komponenten aufgebautes Kameraobjektiv sein kann) auf den flächigen Detektor 62, abgebildet. Der Detektor 62 ist dabei in einer Bildebene des durch die Linsen 28 und 61 gebildeten Objektivs angeordnet, um die Oberfläche der photonischen integrierten Schaltung 29 oder eines Teils hiervon zu beobachten. Die Größe des Strahlteilers 61 bestimmt dabei unter anderem das Beobachtungsfeld. Eine derartige Detektion mittels eines flächigen Detektors und mit großem Beobachtungsfeld ist insbesondere dann hilfreich, wenn verschiedene Auskopplungsports eines untersuchten Wellenleiters der photonischen integrierten Schaltung gleichzeitig beobachtet werden sollen, welche sich in verschiedenen Positionen auf der photonischen integrierten Schaltung befinden, insbesondere wenn sie sich entfernt von einem Eingangsport, an dem der Beleuchtungslichtstrahl 212 eingekoppelt wird, befinden. Zu bemerken ist, dass Detektion der Fig. 6 voraussetzt, dass für die verwendete Wellenlänge geeignete flächige Detektoren 62 bereitstehen, was bei manchen Infrarotwellenlängen schwierig sein kann. Die Testmessungen mit der Vorrichtung der Fig. 6 eignen sich insbesondere für Qualitätsmessungen, beispielsweise zur Überprüfung ob ein optischer Signalpfad in der photonischen integrierten Schaltung 29 korrekt arbeitet.

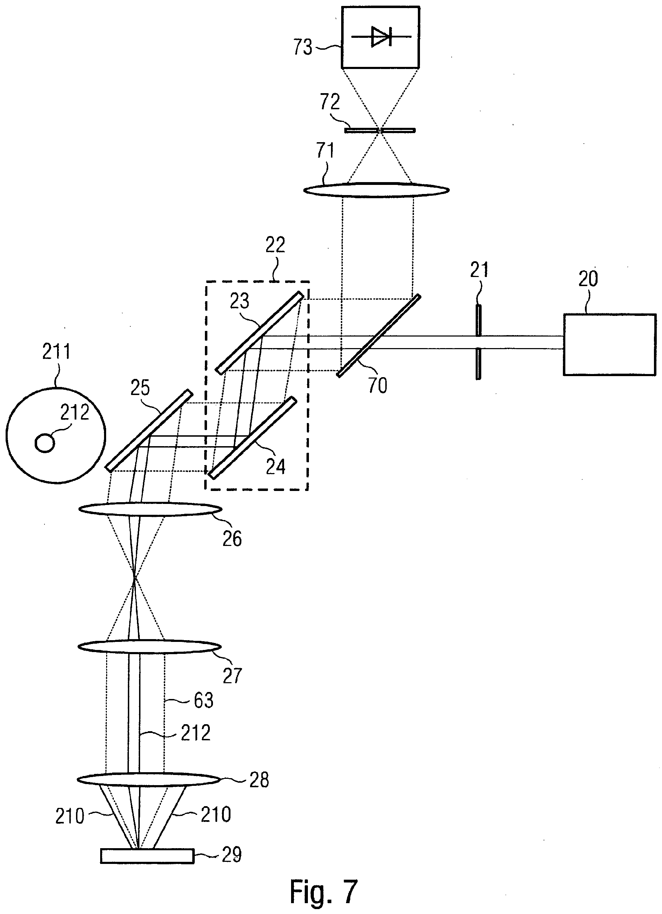

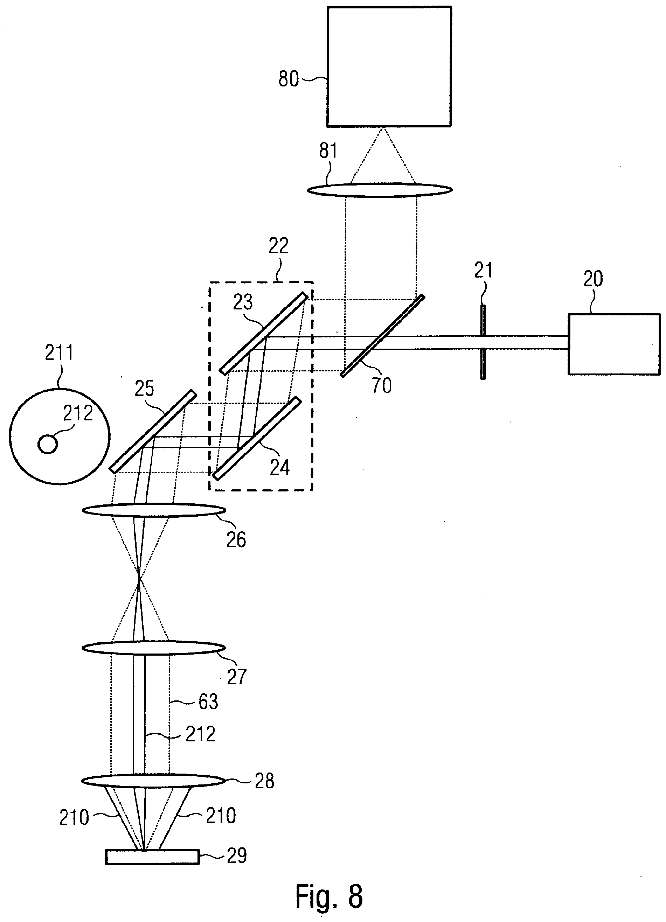

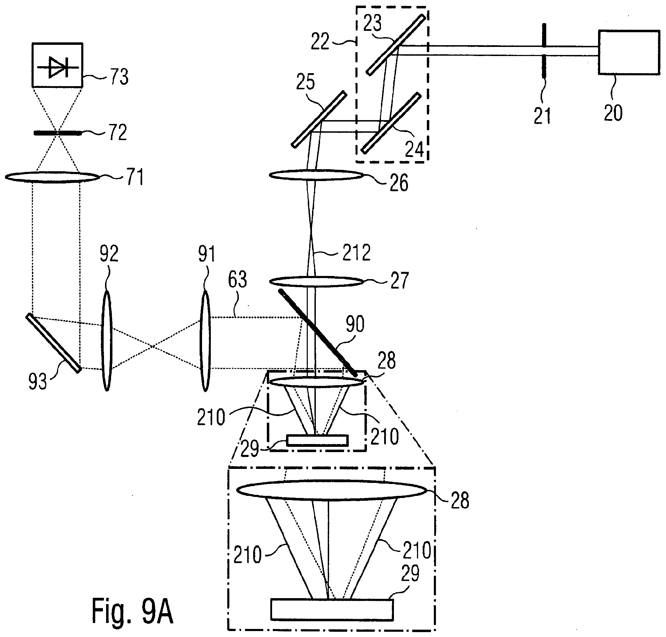

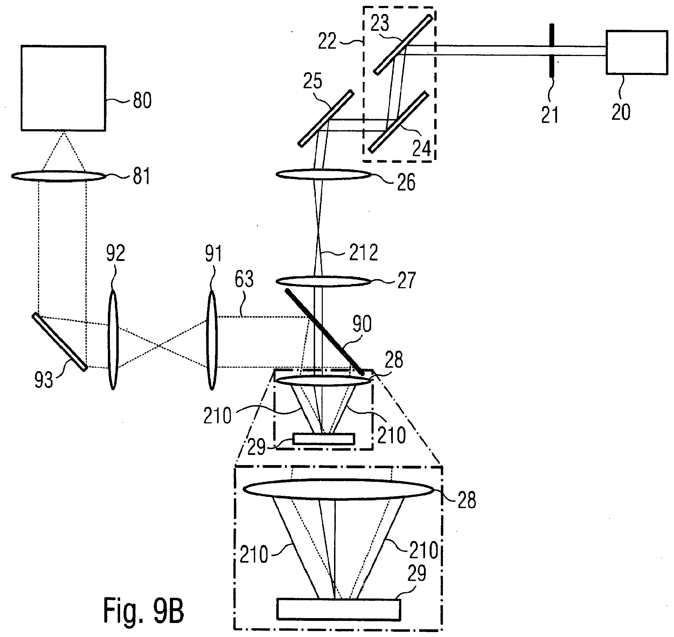

Eine weitere Möglichkeit ist die sogenannte "Descanned"-Detektion, bei welchem Licht von der photonischen integrierten Schaltung 29 zu einer Scaneinrichtung gelangt. Die Detektion erfolgt dann durch einen Punktdetektor wie eine Photodiode, eine Lawinenphotodiode, einen Photonenvervielfacher (Photo Multiplier) oder ein anderes Messsystem wie ein Spektrometer oder ein im Zeitbereich arbeitendes optisches Reflektometer. Hier sind zwei Möglichkeiten gegeben. Bei einer ersten Herangehensweise wird das Detektionslicht an der Position detektiert, an der der Beleuchtungslichtstrahl auf die photonische integrierte Schaltung fällt, wobei in diesem Fall nur eine Scaneinrichtung, beispielsweise ein Scanspiegel, sowohl für den Beleuchtungspfad als auch für den Detektionspfad verwendet wird. Bei einer zweiten Herangehensweise sind die Orte verschieden, und dementsprechend in diesem Fall getrennte Scaneinrichtungen verwendet. Der erste Fall wird nachfolgend unter Bezugnahme auf die Figuren 7 und 8 beschrieben, während der zweite Fall unter Bezugnahme auf die Figuren 9A und 9B beschrieben wird.

Bei dem Ausführungsbeispiel der Fig. 7 ist zwischen der Beamwalk-Einrichtung 22 und der Aperturblende 21 ein Strahlteiler 70 angeordnet, welcher das von der photonischen integrierten Schaltung 29 ausgehende Detektionslicht 63 aus dem Beleuchtungspfad zu einer Linse 71 hin abbildet, welche das Detektionslicht 63 auf ein Pinhole 72 abbildet. Der Lichtstrahl wird dann von einem Punktdetektor 73 detektiert.

Bei dem Ausführungsbeispiel der Fig. 8 ist statt der Linse 71, des Pinhole 72 und des Detektors 73 eine Linse 81 bereitgestellt, welche das ausgekoppelte Detektionslicht 63 auf den Eingang eines Messsystems 80, beispielsweise eines Spektrometers oder eines im Zeitbereich arbeitenden optischen Reflektometers wie oben erwähnt abbildet.

Die Herangehensweise der Figuren 7 und 8 ermöglicht es, Licht zu analysieren, welches an dem von dem Beleuchtungslichtstrahl 212 beleuchteten Eingangsport oder innerhalb der Wellenleiterstruktur, in welche das der Beleuchtungslichtstrahl 212 eingekoppelt wird, reflektiert oder gestreut wird. Während mit dem Detektor der Fig. 7 im Wesentlichen eine einfache Intensitätsdetektion ermöglicht wird, kann ein Messsystem wie das Messsystem 80 weitere Informationen liefern, beispielsweise eine Spektralverteilung des Lichts im Falle eines Spektrometers oder eine Analyse zeitabhängiger Phänomene, beispielsweise Propagationszeiten innerhalb der Wellenleiterstrukturen durch ein im Zeitbereich arbeitendes Reflektometer. Dies kann Rückschlüsse auf die innere Struktur des Wellenleiters (beispielsweise Strahlteiler, Koppler und anderer Elemente, welche eine Reflexion erzeugen) und auf die Funktionalität der Wellenleiterstruktur innerhalb der photonischen integrierten Schaltung ermöglichen.

Die Figuren 9A und 9B zeigen Möglichkeiten für den Fall, in dem von der photonischen integrierten Schaltung 29 ausgehendes Licht an einem anderen Ort detektiert werden soll, als der Beleuchtungslichtstrahl 212 auf die photonische integrierte Schaltung 29 gerichtet ist. Diese verschiedenen Orte sind insbesondere in den Figuren 9A und 9B zusätzlich dargestellten vergrößerten Darstellung der photonischen integrierten Schaltung 29, der Objektivlinse 28 sowie der dazwischen liegenden Teile der Lichtstrahlen ersichtlich.

Bei den Ausführungsbeispielen der Figuren 9A und 9B wird ein Strahlteiler 90 zwischen der Objektivlinse 28 und der Tubuslinse 27 bereitgestellt, welcher das von der photonischen integrierten Schaltung 29 ausgehende Licht aus dem Beleuchtungspfad auskoppelt. Über eine weitere Tubuslinse 91 und eine Scanlinse 92 wird der Lichtstrahl 62 zu einem weiteren Scanspiegel 93 oder anderen Scaneinrichtungen gebracht, durch welche der Detektionsort auf der photonischen integrierten Schaltung 29 veränderlich ist. Der Scanspiegel 93 kann beispielsweise gemäß den verschiedenen für den Scanspiegel 25 bereits erläuterten Möglichkeiten ausgestaltet sein.

Bei dem Ausführungsbeispiel der Fig. 9A wird das Licht dann von dem weiteren Scanspiegel 93 über die schon beschriebene Kombination aus Linse 71 und Pinhole 72 zu dem ebenfalls beschriebenen Detektor 73 gelenkt. Bei dem Ausführungsbeispiel der Fig. 9B ist stattdessen wie bei dem Ausführungsbeispiel der Fig. 8 eine Linse 81 und ein Messsystem 80, das wie bereits unter Bezugnahme auf die Fig. 8 beschrieben, ausgestaltet sein kann, bereitgestellt. Mit den Vorrichtungen der Figuren 9A und 9B können damit beliebige Wellenleiterpfade mit frei auswählbarem Eingang und Ausgang (auswählbar über den Scanspiegel 25 und den weiteren Scanspiegel 93) getestet werden.

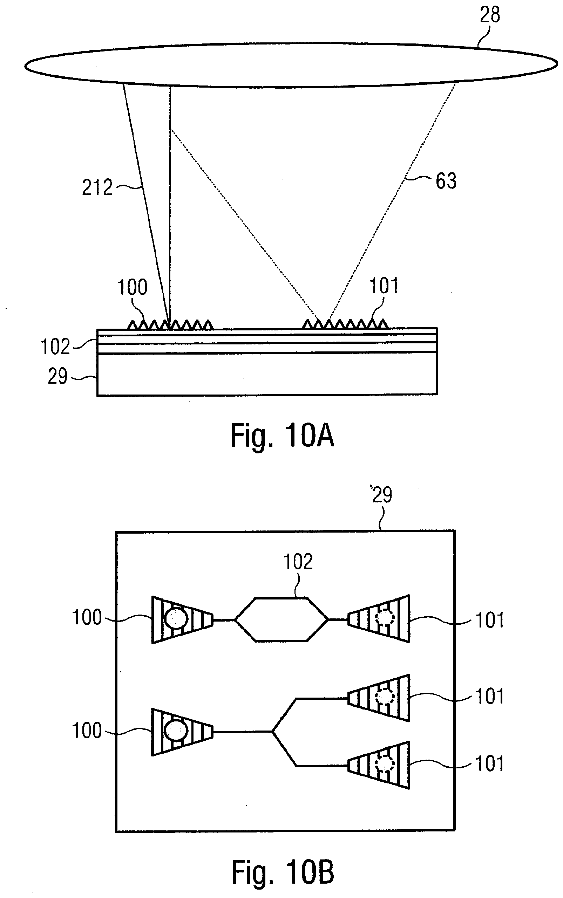

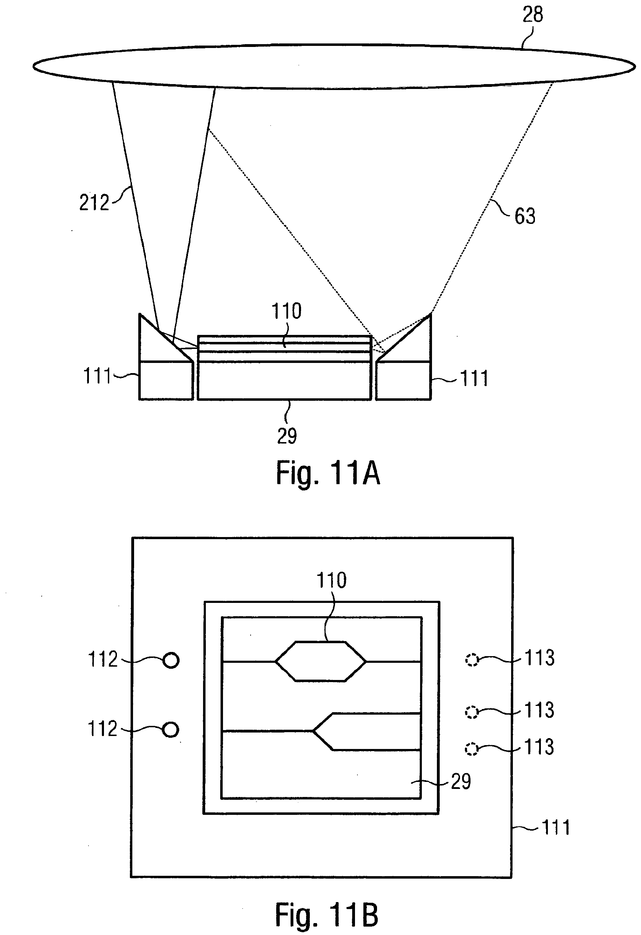

Im Folgenden werden unter Bezugnahme auf die Figuren 10 und 11 noch Kopplungsstrukturen und Probenhalter für photonische integrierte Schaltung beschrieben, welche zusammen mit den vorstehend beschriebenen Vorrichtungen zur Durchführung von Testmessungen verwendet werden können.

Die Fig. 10 zeigt eine Querschnittsansicht einer photonischen integrierten Schaltung 29 zusammen mit der Objektivlinse 28, dem Beleuchtungslichtstrahl 212 und dem Detektionsstrahl 63, und die Fig. 10B zeigt eine Draufsicht auf die photonische integrierte Schaltung 29. Die photonische integrierte Schaltung 29 weist in dem Beispiel der Figuren 10A und 10B Wellenleiterstrukturen 102 auf, welche mit weiteren (nicht dargestellten) optischen Komponenten der photonisch integrierten Schaltung gekoppelt sind. Ein Kopplungsgitter 100 und Auskopplungsgitter 101 sind bereitgestellt, um eine Einkopplung bzw. Auskopplung des Beleuchtungslichtstrahls 212 bzw. des Detektionsstrahls 63 in und aus den Wellenleiterstrukturen 102 zu ermöglichen. Die verschiedenen Einkopplungsgitter 100 und bei Bedarf auch die verschiedenen Auskopplungsgitter 101 können mit den vorstehend beschriebenen Vorrichtungen durch das Vorsehen von Scannereinrichtungen präzise "angefahren" werden, um so Testmessungen zu ermöglichen. Die Kopplungsgitter 100, 101 koppeln Licht aus der Ebene der Wellenleiter 102 annähernd senkrecht zu der Oberfläche der photonischen integrierten Schaltung 29 ein und aus. Diese Art von Kopplungsgittern hat den Vorteil, dass sie sowohl auf Waferebene (vor dem Zerteilen, Dicing des Wafers) als auch nach dem Verteilen für verschiedene Bauelemente angewendet werden können. Eine Alternative sind Kantenkoppler, die aus abgeschrägten Wellenleitern nahe der Chipkante bestehen. Dies kann jedoch nur bei bereits zerteilten Wafern und vereinzelten Chips angewendet werden, wenn diese Chipränder (Endfacetten) zugänglich sind.

Zudem ist das Koppeln in Endfacetten von Chips schwieriger, da sie bei der in den Figuren 2-9 dargestellten Lage der photonischen integrierten Schaltung nicht direkt zugänglich sind. Bei manchen Ausführungsbeispielen kann daher die photonische integrierte Schaltung "senkrecht", d.h. mit dem Rand dem optischen Aufbau zugewandt, angeordnet sein, wobei in diesem Fall immer nur eine Seite des Randes zugänglich ist. Bei einem bevorzugten Ausführungsbeispiel wird alternativ hierzu ein spezieller Probenhalter bereitgestellt, welcher nunmehr unter Bezugnahme auf die Figuren 11A und 11B erläutert wird. Die Fig. 11A zeigt dabei eine Querschnittsansicht der photonischen integrierten Schaltung 29 zusammen mit der Objektivlinse 28, dem Beleuchtungslichtstrahl 212 und dem Detektionslicht 63 sowie einem Probenhalter 111, und die Fig. 11B zeigt eine entsprechende Draufsicht. Bei der dem Ausführungsbeispiel der Fig. 11 weist der Probenhalter 111 einen Rahmen von Spiegeln oder Prismen auf, welcher Licht von der Testvorrichtung der Figuren 2-9 um etwa 90° ablenkt und so in Wellenleiterstrukturen 110 einkoppelt. Dieser Rahmen von Spiegeln ist ein Beispiel für eine Strahlablenkungseinrichtung, die um eine Aufnahme für die photonische integrierte Schaltung 29 herum angeordnet ist. Die photonische integrierte Schaltung 29 wird hierzu nach dem Zerteilen und gegebenenfalls Polieren der Endfacetten in dem Rahmen positioniert, so dass Licht in Wellenleiterstrukturen ein- und ausgekoppelt werden kann. Wie in der Draufsicht der Fig. 11B ersichtlich, können dann auf diesem Rand (d.h. in Prismen oder Spiegelstrukturen) Orte 112 zur Einkopplung und Orte 113 zur Auskopplung mittels Scaneinrichtungen ausgewählt werden, um Licht selektiv in Wellenleiterstrukturen 110 einzukoppeln und selektiv zu empfangen, um die oben diskutierten Tests durchführen zu können.

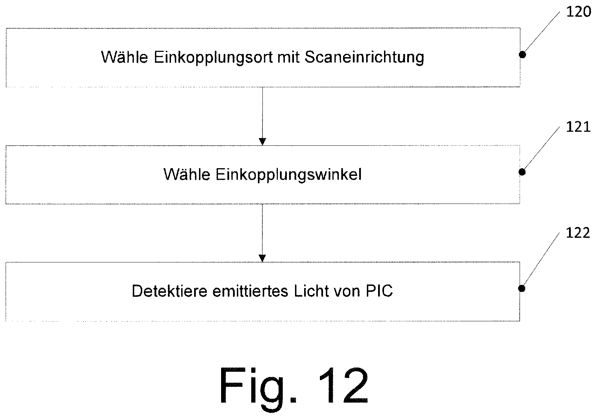

Die Fig. 12 zeigt ein Flussdiagramm zur Veranschaulichung eines Verfahrens gemäß einem Ausführungsbeispiel. Während das Verfahren in Fig. 12 als Abfolge von Schritten dargestellt ist, ist dies nicht als einschränkend auszulegen, da die dargestellten Schritte teilweise auch gleichzeitig oder in anderer Reihenfolge (insbesondere die Schritte 120 und 121) stattfinden können. Das Verfahren der Fig. 12 wird im Folgenden unter Bezugnahme auf die Vorrichtungen der Figuren 1-9 beschrieben und kann mittels dieser Vorrichtungen implementiert werden, aber auch unabhängig hiervon verwendet werden. Variationen und Modifikationen sowie Details, die für die Vorrichtungen beschrieben wurden, sind in entsprechender Weise auch auf das Verfahren der Fig. 12 anwendbar.

In Schritt 120 wird ein Kopplungsort für Beleuchtungslicht auf einer photonischen integrierten Schaltung mit einer Scaneinrichtung gewählt, beispielsweise der Scaneinrichtung 11 der Fig. 1 oder dem Scanspiegel 25 der Figuren 2-9. Optional kann zudem in Schritt 121 ein Einkopplungswinkel gewählt werden, beispielsweise durch Auswahl einer Pupille für einen Beleuchtungslichtstrahl, wie für die Beamwalk-Einrichtung 22 der Fig. 2 oder den räumlichen Lichtmodulator 31 der Fig. 3 beschrieben.

Das Verfahren umfasst dann weiterhin in Schritt 122 ein Detektieren von emittiertem Licht (Detektionslicht) von der photonischen integrierten Schaltung, wobei dies flächig oder ortsaufgelöst erfolgen kann, wie ebenfalls bereits für die Vorrichtungen der Figuren 6-9 beschrieben.

Angesichts der vielen verschiedenen beschriebenen Varianten und Ausführungsbeispiele ist ersichtlich, dass diese nur als Beispiele dienen und nicht als einschränkend auszulegen sind.

## Patentansprüche

1. Vorrichtung zum Testen photonischer integrierter Schaltungen (12), umfassend:
eine Lichtquelle (10; 20) zum Erzeugen eines Beleuchtungslichtstrahls (212),
einen Beleuchtungspfad zum Lenken des Beleuchtungslichtstrahls auf eine photonische integrierte Schaltung (29), und
eine Detektionseinrichtung (13) mit einem Detektionspfad zum Detektieren von der photonischen integrierten Schaltung (12) in Antwort auf den Beleuchtungslichtstrahl (212) ausgehenden Licht (63),
**dadurch gekennzeichnet, dass** der Beleuchtungspfad eine Scaneinrichtung (11; 25) mit welcher eine Fläche einer photonischen integrierten Schaltung oder einer Umgebung hiervon mit einem Lichtstrahl abgerastert werden kann zur Wahl eines Beleuchtungsortes (14) umfasst.

2. Vorrichtung nach Anspruch 1, weiter umfassend eine Pupillenauswahleinrichtung (22, 31), um eine Position des Beleuchtungslichtstrahls (212) in einer Pupillenebene (211) des Beleuchtungspfades festzulegen.

3. Vorrichtung nach Anspruch 2, wobei die Pupillenauswahleinrichtung (22) eine erste verstellbare Spiegeleinrichtung (23) und einen zweiten verstellbare Spiegeleinrichtung (24) umfasst.

4. Vorrichtung nach Anspruch 2 oder 3, wobei die Pupillenauswahleinrichtung (22, 31) einen räumlichen Lichtmodulator (31) umfasst.

5. Vorrichtung nach Anspruch 4, wobei der räumliche Lichtmodulator (31) eingerichtet ist, mindestens zwei Beleuchtungslichtstrahlen (212A, 212B) zu erzeugen.

6. Vorrichtung nach einem der Ansprüche 1-5, wobei die Detektionseinrichtung einen 2D-Detektor (62) umfasst.

7. Vorrichtung nach Anspruch 6, wobei der 2D-Detektor (62) einen Bildsensor umfasst.

8. Vorrichtung nach einem der Ansprüche 1-7, wobei die Detektionseinrichtung (13) einen Punktdetektor (73) umfasst.

9. Vorrichtung nach einem der Ansprüche 1-8, wobei die Detektionseinrichtung (13) ein Spektrometer und/oder ein im Zeitbereich arbeitendes optisches Reflektometer (80) umfasst.

10. Vorrichtung nach einem der Ansprüche 1-9, wobei der Detektionspfad die Scaneinrichtung umfasst.

11. Vorrichtung nach einem der Ansprüche 1-10, wobei der Detektionspfad eine weitere Scaneinrichtung (93) umfasst.

12. Vorrichtung nach einem der Ansprüche 1-11, weiterhin umfassend einen Probenhalter (111), wobei der Probenhalter eine Aufnahme für die photonische integrierte Schaltung (29) und eine um die Aufnahme herum angeordnete Strahlablenkungseinrichtung zum Ablenken eines Lichtstrahls zu oder von der Vorrichtung umfasst.

13. Vorrichtung nach Anspruch 12, wobei die Strahlablenkungseinrichtung ein Prisma oder einen Spiegel umfasst.

14. Verfahren zum Testen einer photonischen integrierten Schaltung, umfassend:
Auswählen eines Beleuchtungsortes eines Beleuchtungslichtstrahls (212) zum Beleuchten der photonischen integrierten Schaltung (29), und
Detektieren von von der photonischen integrierten Schaltung ausgehendem Detektionslicht,
**dadurch gekennzeichnet, dass** der Beleuchtungsort mit einer Scaneinrichtung mit welcher eine Fläche einer photonischen integrierten Schaltung oder einer Umgebung hiervon mit einem Lichtstrahl abgerastert werden kann ausgewählt wird.

15. Verfahren nach Anspruch 14, weiter umfassend Wählen eines Einkopplungswinkels des Lichtstrahls durch Einstellen einer Position des Beleuchtungslichtstrahls (212) in einer Pupillenebene (211) eines Beleuchtungspfades für den Beleuchtungslichtstrahl (212).

16. Verfahren nach Anspruch 14 oder 15, weiterhin umfassend Auswählen eines Detektionsortes für das Detektionslicht (63).

## Claims

1. Apparatus for testing photonic integrated circuits (12), comprising:
a light source (10; 20) for producing an illumination light beam (212),
an illumination path for steering the illumination light beam onto a photonic integrated circuit (29), and
a detection device (13) having a detection path for detecting light (63) coming from the photonic integrated circuit (12) as a reaction to the illumination light beam (212) ,
**characterized in that** the illumination path comprises a scanning device (11; 25) with which a surface of a photonic integrated circuit or a surrounding area thereof can be scanned using a light beam, for selecting an illumination location (14).

2. Apparatus according to Claim 1, furthermore comprising a pupil selection device (22, 31) for defining a position of the illumination light beam (212) in a pupil plane (211) of the illumination path.

3. Apparatus according to Claim 2, wherein the pupil selection device (22) comprises a first adjustable mirror device (23) and a second adjustable mirror device (24).

4. Apparatus according to Claim 2 or 3, wherein the pupil selection device (22, 31) comprises a spatial light modulator (31).

5. Apparatus according to Claim 4, wherein the spatial light modulator (31) is configured to produce at least two illumination light beams (212A, 212B).

6. Apparatus according to any of Claims 1-5, wherein the detection device comprises a 2D detector (62).

7. Apparatus according to Claim 6, wherein the 2D detector (62) comprises an image sensor.

8. Apparatus according to any of Claims 1-7, wherein the detection device (13) comprises a point detector (73) .

9. Apparatus according to any of Claims 1-8, wherein the detection device (13) comprises a spectrometer and/or an optical reflectometer (80) operating in the time domain.

10. Apparatus according to any of Claims 1-9, wherein the detection path comprises the scanning device.

11. Apparatus according to any of Claims 1-10, wherein the detection path comprises a further scanning device (93) .

12. Apparatus according to any of Claims 1-11, further comprising a sample holder (111), wherein the sample holder comprises a receptacle for the photonic integrated circuit (29) and a beam deflection device, arranged around the receptacle, for deflecting a light beam to or from the apparatus.

13. Apparatus according to Claim 12, wherein the beam deflection device comprises a prism or a mirror.

14. Method for testing a photonic integrated circuit, comprising:
selecting an illumination location of an illumination light beam (212) for illuminating the photonic integrated circuit (29), and
detecting detection light coming from the photonic integrated circuit,
**characterized in that** the illumination location is selected using a scanning device with which a surface of a photonic integrated circuit or a surrounding area thereof can be scanned using a light beam.

15. Method according to Claim 14, further comprising selecting an input coupling angle of the light beam by setting a position of the illumination light beam (212) in a pupil plane (211) of an illumination path for the illumination light beam (212).

16. Method according to Claim 14 or 15, furthermore comprising selecting a detection location for the detection light (63).

## Revendications

1. Dispositif permettant de tester des circuits intégrés photoniques (12), comprenant :
une source de lumière (10 ; 20) pour produire un faisceau lumineux d'éclairage (212),
un chemin d'éclairage pour diriger le faisceau lumineux d'éclairage sur un circuit intégré photonique (29), et
un équipement de détection (13) pourvu d'un chemin de détection pour détecter la lumière (63) émanant du circuit intégré photonique (12) en réponse au faisceau de lumière d'éclairage (212),
**caractérisé en ce que** le chemin d'éclairage comprend un équipement de balayage (11 ; 25) qui permet de quadriller une surface d'un circuit intégré photonique ou d'un environnement de celui-ci à l'aide d'un faisceau lumineux pour sélectionner un emplacement d'éclairage (14).

2. Dispositif selon la revendication 1, comprenant en outre un équipement de sélection de pupille (22, 31) pour fixer une position du faisceau lumineux d'éclairage (212) dans un plan de pupille (211) du chemin d'éclairage.

3. Dispositif selon la revendication 2, dans lequel l'équipement de sélection de pupille (22) comprend un premier équipement de miroir réglable (23) et un deuxième équipement de miroir réglable (24).

4. Dispositif selon la revendication 2 ou 3, dans lequel l'équipement de sélection de pupille (22, 31) comprend un modulateur spatial de lumière (31).

5. Dispositif selon la revendication 4, dans lequel le modulateur spatial de lumière (31) est conçu pour produire au moins deux faisceaux lumineux d'éclairage (212A, 212B).

6. Dispositif selon l'une quelconque des revendications 1 à 5, dans lequel l'équipement de détection comprend un détecteur 2D (62).

7. Dispositif selon la revendication 6, dans lequel le détecteur 2D (62) comprend un capteur d'image.

8. Dispositif selon l'une quelconque des revendications 1 à 7, dans lequel l'équipement de détection (13) comprend un détecteur ponctuel (73).

9. Dispositif selon l'une quelconque des revendications 1 à 8, dans lequel l'équipement de détection (13) comprend un spectromètre et/ou un réflectomètre optique (80) fonctionnant dans le domaine temporel.

10. Dispositif selon l'une quelconque des revendications 1 à 9, dans lequel le chemin de détection comprend l'équipement de balayage.

11. Dispositif selon l'une quelconque des revendications 1 à 10, dans lequel le chemin de détection comprend un autre équipement de balayage (93) .

12. Dispositif selon l'une quelconque des revendications 1 à 11, comprenant en outre un porte-échantillon (111), dans lequel le porte-échantillon comprend un logement pour le circuit intégré photonique (29) et un équipement de déviation de faisceau disposé autour du logement pour dévier un faisceau lumineux vers le dispositif ou pour l'écarter de celui-ci.

13. Dispositif selon la revendication 12, dans lequel l'équipement de déviation de faisceau comprend un prisme ou un miroir.

14. Procédé permettant de tester un circuit intégré photonique, comprenant les étapes consistant à :
sélectionner un emplacement d'éclairage d'un faisceau lumineux d'éclairage (212) pour éclairer le circuit intégré photonique (29), et
détecter la lumière de détection émanant du circuit intégré photonique,
**caractérisé en ce que** l'emplacement d'éclairage peut être sélectionné à l'aide d'un équipement de balayage qui permet de quadriller une surface d'un circuit intégré photonique ou d'un environnement de celui-ci à l'aide d'un faisceau lumineux.

15. Procédé selon la revendication 14, comprenant en outre la sélection d'un angle d'injection du faisceau lumineux par le réglage d'une position du faisceau lumineux d'éclairage (212) dans un plan de pupille (211) d'un chemin d'éclairage pour le faisceau de lumière d'éclairage (212).

16. Procédé selon la revendication 14 ou 15, comprenant en outre la sélection d'un emplacement de détection pour la lumière de détection (63).
